# FASCICULE DE BREVET EUROPEEN

(11) **EP 2 326 601 B1**
(45) Date de publication et mention de la délivrance du brevet: **05.06.2013**
(21) Numéro de dépôt: 09752413.6
(22) Date de dépôt: 25.09.2009
(51) Int. Cl.: C03C 17/00, C03C 17/36, C03C 17/40, H01L 51/52, H01L 51/56, H01L 51/10

(54) **PROCEDE DE FABRICATION D'UNE GRILLE SUBMILLIMETRIQUE ELECTROCONDUCTRICE REVETUE D'UNE SURGRILLE ET GRILLE SUBMILLIMETRIQUE ELECTROCONDUCTRICE REVETUE D'UNE SURGRILLE**
VERFAHREN ZUR HERSTELLUNG EINES MIT EINEM ÜBERGITTER BESCHICHTETEN SUBMILLIMETRISCHEN ELEKTRISCH LEITFÄHIGEN GITTERS UND MIT EINEM ÜBERGITTER BESCHICHTETES SUBMILLIMETRISCHES ELEKTRISCH LEITFÄHIGES GITTER
METHOD FOR MANUFACTURING A SUBMILLIMETRIC ELECTRICALLY CONDUCTIVE GRID COATED WITH AN OVERGRID, AND SUBMILLIMETRIC ELECTRICALLY CONDUCTIVE GRID COATED WITH AN OVERGRID

(30) Priorité: 25.09.2008 FR 0856448
(43) Date de publication de la demande: 01.06.2011
(73) Titulaire: Saint-Gobain Glass France, 92400 Courbevoie (FR)
(72) Inventeur: ZAGDOUN, Georges, F-92250 La Garenne Colombes (FR); NGHIEM, Bernard, F-60190 Arsy (FR); ROYER, Eddy, F-93250 Villemomble (FR)
(74) Mandataire: Cardin, Elise
(86) Numéro de dépôt international: PCT/FR2009/051822
(87) Numéro de publication internationale: WO 2010/034950

(56) Documents cités:
- US-B2- 7 172 822
- RAINER ADELUNG ET AL: "Strain-controlled growth of nanowires within thin-film cracks" NATURE MATERIALS, NATURE PUBLISHING GROUP, LONDON, GB, vol. 3, 1 juin 2004 (2004-06-01), pages 375-379, XP002453921 ISSN: 1476-4660

## Description

La présente invention a pour objet un procédé de réalisation d'une grille électroconductrice submillimétrique revêtue d'une surgrille et une telle grille revêtue d'une surgrille.

On connaît des techniques de fabrication permettant l'obtention de grilles métalliques de taille micronique. Celles-ci présentent l'avantage d'atteindre des résistances surfaciques inférieures à 1 Ohm/carré tout en conservant une transmission lumineuse (T_{L}) de l'ordre de 75 à 85 %. Le procédé d'obtention de ces grilles est basé sur une technique de gravure d'une couche métallique soit par l'intermédiaire d'un procédé photolithographique associé à un procédé d'attaque chimique par voie liquide, soit par une technique d'ablation laser.

On connaît également des techniques de formation d'une grille électroconductrice par l'utilisation d'un masque sol-gel micro-fissuré, tel que décrit dans US 7 172 822.

Par ailleurs, on connait des grilles électroconductrices autosupportées basées sur le tissage des fils métalliques ou de polymères recouverts de métal, utilisées pour le blindage électromagnétique. Ces grilles présentent des brins de dimension d'au moins 20 µm. Ces grilles sont mécaniquement peu résistantes, avec des défauts de planéité, et nécessitent une tension contrôlée pour lors du tissage et de la mise en oeuvre, sous peine de défauts nombreux, de déformation des mailles, de déchirement, de détricotage, ....

En outre, dans certaines applications on cherche revêtir la grille électroconductrice submillimétrique.

Par exemple, pour des raisons esthétiques, dans les pares brises automobiles, on noircit la grille chauffante en fils tissés de tungstène ou de cuivre par du graphite. Les fils métalliques sont noircis (enduction par une suspension de graphite) avant le tissage, ou le tricotage de la grille.

La présente invention vise donc à pallier les inconvénients des procédés de l'art antérieur en proposant un procédé de fabrication d'une grille submillimétrique électroconductrice revêtue, économique, rapide et/ou simplifié (limitation du nombre d'étapes de fabrication, ...), reproductible.

L'invention a aussi pour but d'élargir les gammes de produits disponibles à base de grille électroconductrice, notamment en rendant possible de nouvelles fonctionnalités.

Les propriétés optiques et/ou les propriétés de conductivité électrique de cette grille sont au moins comparables à celles des techniques antérieures.

A cet effet, l'invention a d'abord pour objet un procédé de fabrication d'une grille électroconductrice submillimétrique, notamment submicronique (au moins pour la largeur de grille), revêtue d'une surgrille, sur une face principale d'un substrat, notamment plan et/ou transparent, comportant
- la réalisation d'un masque à ouvertures submillimétriques, dit masque à réseau, sur la face principale, incluant :
   - le dépôt d'une couche de masquage à partir d'une solution de nanoparticules colloïdales polymériques stabilisées et dispersées dans un solvant, les particules polymériques ayant une température de transition vitreuse Tg donnée,
   - le séchage de la couche de masquage à une température inférieure à ladite température Tg jusqu'à l'obtention du masque à réseau d'ouvertures, avec des bords de zones de masque sensiblement droits,
- la formation de la grille électrocondutrice à partir du masque à réseau comportant un dépôt d'au moins un matériau électroconducteur, dit de grille, jusqu'à remplir une fraction de la profondeur des ouvertures,
- un traitement thermique (local ou non) de la couche de masquage avec le matériau de grille à une température supérieure ou égale à 0,8 fois Tg, notamment entre Tg et 1,5 fois Tg, conduisant à un rétrécissement des zones de masque, créant ainsi un espace entre les bords de zones de masque et les bords latéraux de la grille,
   - un dépôt d'une couche, dite surcouche, en un matériau dit de surcouche sur la grille et dans l'espace entre les bords de zones de masque et les bords latéraux de la grille,
   - un enlèvement de la couche de masquage, jusqu'à laisser révéler la grille électrocondutrice revêtue de la surgrille.

Le masque à réseau d'ouvertures selon l'invention et sa méthode de fabrication selon l'invention présentent un certain nombre d'atouts pour la grille envisagée. Les atouts liés à l'ajout d'un traitement thermique et d'une surgrille seront explicités ensuite.

Le masque possède ainsi une structure aléatoire, apériodique sur au moins une direction caractéristique du réseau (donc parallèle à la surface du substrat), voire sur deux (toutes les) directions. L'arrangement des brins de la grille peut être alors sensiblement la réplique de celle du réseau d'ouvertures.

Les bords des zones du masque à réseau sont sensiblement droits c'est à dire suivant un plan moyen compris entre 80 et 100° par rapport à la surface (si la surface est courbe par rapport au plan tangentiel), voire même entre 85° et 95°.

Grâce aux bords droits des zones de masque (avant comme après le traitement thermique) :
- la couche déposée formant la grille est discontinue (pas ou peu de dépôt le long des bords),
- la couche déposée formant la surgrille est discontinue (pas ou peu de dépôt le long des bords).

On peut ainsi retirer le masque (même revêtu de la grille et de la surgrille) sans abîmer la surgrille et la grille recouverte.

Pour obtenir les bords sensiblement droits, il est nécessaire à la fois :
- de choisir des particules de taille limitée, donc des nanoparticules, pour favoriser leur dispersion, avec préférablement au moins une dimension caractéristique (moyenne), par exemple le diamètre moyen, entre 10 et 300 nm, voire entre 50 et 150 nm,
- de stabiliser les nanoparticules dans le solvant (notamment par traitement par des charges de surface, par exemple par un tensioactif, par contrôle du pH), pour éviter qu'elles ne s'agglomèrent entre elles, qu'elles précipitent et/ou qu'elles ne tombent par gravité.

En outre, on ajuste la concentration des nanoparticules, préférablement entre 5%, voire 10% et 60% en poids, encore plus préférentiellement entre 20% et 40 %. On évite l'ajout de liant (ou en quantité suffisamment faible pour ne pas influer sur le masque).

Grâce à ce procédé particulier, il est possible d'obtenir, à moindre coût, un masque constitué de motifs aléatoires (forme et/ou taille), apériodiques de dimensions caractéristiques adaptées :
- largeur (moyenne) des ouvertures du réseau A choisie micronique (autrement dit la distance entre zones de masque adjacentes), voire largeur A nanométrique, en particulier entre quelques centaines de nanomètres à quelques dizaines de micromètres, notamment entre 200 nm et 50 µm,
- taille (moyenne) d'une zone de masque ou motif B (donc taille entre ouvertures adjacentes) millimétrique voire submillimétrique, notamment compris entre 5 à 500 µm, voire 100 à 250 µm,
- rapport B/A ajustable notamment en fonction de la nature des particules, notamment entre 7 et 20 voire 40,
- écart entre la largeur maximale d'ouvertures et la largeur minimale d'ouvertures inférieur à 4, voire inférieur ou égal à 2, dans une région donnée du masque, voire sur la majorité ou toute la surface,
- écart entre la dimension maximale de motif et la dimension minimale de motif inférieur à 4, voire inférieur ou égal à 2, dans une région donnée du masque, voire sur la majorité ou même toute la surface,
- le taux de motif ouverte (ouverture non débouchante, « en aveugle »), autrement dit taux de rupture d'interconnexions, est inférieur à 5%, voire inférieure ou égale 2%, dans une région donnée du masque, voire sur la majorité ou toute la surface, donc avec une rupture de réseau limité voir quasi nul, éventuellement réduite, et supprimable par gravure du réseau,
- pour un motif donné, la majorité voire tous les motifs, dans une région donnée ou sur toute la surface, l'écart entre la plus grande dimension caractéristique de motif et la plus petite dimension caractéristique de motif est inférieure à 2, pour renforcer l'isotropie,
- pour la majorité voire tous les segments du réseau, les bords sont d'écartement constant, parallèles, notamment à l'échelle de 10 µm (par exemple observé au microscope optique avec un grossissement de 200).

La largeur A peut être par exemple entre 1 et 20 µm, voire entre 1 et 10 µm, et B entre 50 et 200 µm.

Par le procédé selon l'invention, on peut former ainsi un maillage d'ouvertures, qui peuvent être réparties sur toute la surface, permettant d'obtenir des propriétés isotropes.

L'épaisseur du masque peut être submicronique jusqu'à plusieurs dizaines de microns. Plus l'épaisseur de la couche de masque est grande, plus la largeur A (et B) est grand.

Les motifs délimités par les ouvertures (et donc les mailles de grilles et/ de surgrille) sont de formes diverses, typiquement trois, quatre, cinq cotés, par exemple majoritairement quatre cotés, et/ou de taille diverses, distribuées de façon aléatoire, apériodique.

Pour la majorité voire tous les motifs (respectivement les mailles), l'angle entre deux cotés adjacents d'une maille peut être compris entre 60° et 110°, notamment entre 80° et 100°.

Dans une configuration, on obtient un réseau principal avec des ouvertures (éventuellement approximativement parallèles) et un réseau secondaire d'ouvertures (éventuellement approximativement perpendiculaires au réseau parallèle), dont la localisation et la distance sont aléatoires. Les ouvertures secondaires ont une largeur par exemple inférieure aux ouvertures principales.

Ceci permet de réaliser par la suite une grille définie par une largeur de brin A' moyenne sensiblement identique à la largeur des ouvertures A et un espace (moyen) entre les brins B' sensiblement identique à l'espace entre les ouvertures B (d'une maille).

En particulier les tailles des brins A' peuvent de préférence être comprises entre quelques dizaines de micromètres à quelques centaines de nanomètres. Le rapport B'/A' peut être choisi entre 7 et 20, voire 30 à 40.

En outre, les dimensions caractéristiques des grilles de l'art antérieur faites par photolithographie, généralement de forme régulière et périodique (carré, rectangulaire), constituent des réseaux de brins métalliques de 20 à 30 µm de large espacés par exemple de 300 µm, qui sont à l'origine, lorsqu'ils sont éclairés par une source lumineuse ponctuelle, de motifs de diffraction. Et il serait encore plus difficile et coûteux de faire des grilles avec des motifs aléatoires. Chaque motif à réaliser nécessiterait un masque spécifique.

Cette technique de fabrication de l'art antérieur a par ailleurs une limite de résolution de l'ordre de quelques dizaines de µm, laissant les motifs esthétiquement visibles.

Le tissage de fils très fins présente lui aussi des défauts, notamment la nécessité d'un diamètre des fils relativement grand (supérieur à 40 µm). Et le tissage ne peut que produire des motifs périodiques.

Le masque à réseau selon l'invention permet donc d'envisager à moindre cout, des grilles irrégulières, d'autres formes, de toute taille. La grille ainsi est aléatoire dans au moins une direction (de grille).

Le séchage provoque une contraction de la couche de masquage et une friction des nanoparticules au niveau de la surface induisant une contrainte de traction dans la couche qui, par relaxation, forme les ouvertures.

Après séchage on obtient ainsi un empilement de nanoparticules, sous forme d'amas de taille variable et séparés par les ouvertures elle-même de taille variable. Les nanoparticules restent discernables même si elles peuvent s'agréger. Les nanoparticules ne sont pas fondues pour former une couche continue.

Le séchage est réalisé à une température inférieure à la température de transition vitreuse pour la création du réseau d'ouvertures. Il a en effet été observé qu'au-dessus de cette température de transition vitreuse, on formait une couche continue ou à tout le moins sans ouvertures courant sur toute l'épaisseur.

On dépose ainsi sur le substrat une couche faiblement adhérente simplement constituée d'un empilement de nanoparticules (dures), de préférence sphériques. Ces nanoparticules dures n'établissent pas de liaisons chimiques fortes, ni entre elles ni avec la surface du substrat. La cohésion de la couche est tout de même assurée par des forces faibles, du type forces de Van der Waals ou forces électrostatiques.

Les plots étant constitués d'un amas de nanoparticules: sous l'action de la température lors du traitement thermique, les zones de masque ou plots semblent se densifier. La taille des plots (B) est diminuée : leur surface (ainsi que l'épaisseur) sont réduites. Il y a ainsi par ce traitement thermique modification dans les dimensions caractéristiques du masque : rapport entre l'ouverture des mailles et la largeur des mailles.

De préférence, la durée de chauffe est ajustée en fonction de la température du traitement. Typiquement la durée peut être inférieure à 1h, de préférence de 1 min à 30 min.

La compaction du masque, en outre, provoque une amélioration de l'adhésion de celui-ci sur le substrat ce qui le rend plus manipulable (on évite son écaillage) tout en gardant les étapes d'enlèvement possible (simple lavage à l'eau si le colloïde a été déposé à partir d'une solution aqueuse).

Le traitement thermique peut être local ou sur toute la surface de grille.

La ou les zones modifiées par le traitement thermique peuvent être périphériques ou centrales, de toute forme.

Par traitement thermique de compaction du masque de colloïde il est donc possible de modifier - localement ou sur toute la surface - ses dimensions caractéristiques sans avoir recours à un nouveau masque (cas de la photolithographie ou de la gravure).

Il est alors possible de modifier localement la forme des mailles (largeur, hauteur) et de créer des zones à gradient de conductivité. On peut chauffer localement en maintenant froid le reste.

Le rapport B/A peut être alors différent, par exemple au moins double, dans une première région de grille et dans une deuxième région de grille. Les première et deuxième régions peuvent être de forme distincte ou égale et/ou de taille distincte ou égale.

Avec un rapport ouverture de la maille / taille des brins variable, il est possible de ce fait de créer des zones avec :
- un gradient de transmission lumineuse,
- un gradient de puissance électrique (application au chauffage, dégivrage, réalisation de flux thermique homogène sur des surfaces non rectangulaire).

De la même façon, le dépôt de la surgrille peut être dans l'ensemble de la zone de grille traitée thermiquement ou dans une ou des parties de cette zone.

Le traitement thermique libère un espace suffisant avec les bords des plots et les bords latéraux de la grille pour qu'un dépôt additionnel puisse couvrir la grille (de préférence entièrement) et l'entourer.

La surgrille peut servir pour protéger une grille éventuellement peu adhérente, lors de l'enlèvement du masque et lors des opérations ultérieures.

Les bords de grille sont inclinés, du fait des bords droits de masque et de la méthode de dépôt de la surgrille (de type PVD de préférence), la surgrille est donc continue et couvre entièrement la grille. L'épaisseur de la surgrille n'est pas forcement constante (par exemple plus faible sur les flancs de la grille).

Par une techniques de type photolithographie, il ne serait pas possible de réaliser une telle surgrille en une étape. Il faudrait refaire un masquage avec alignement et ensuite lift off, ce qui est onéreux et complexe.

Le procédé peut en outre comprendre le dépôt d'une couche, dite sous grille, au travers les ouvertures et sous la grille, notamment une sous-grille d'adhésion de la grille, une sous grille barrière aux alcalins ....

Par le procédé selon l'invention, on s'affranchit des techniques de type photolithographie, particulièrement complexe et onéreuse lorsqu'il s'agit de graver plusieurs couches de matériaux. Cela nécessite de trouver une solution de gravure gravant à la même vitesse les différents matériaux empilés pour éviter les surgravures.

Comme couche promotrice d'adhésion du matériau de grille notamment métallique (argent, or, cuivre..), notamment sur du verre, on peut choisir une couche à base de NiCr, de Ti, Nb, Al, d'oxyde métallique simple ou mixte, dopé ou non, (ITO...), couche par exemple d'épaisseur inférieure ou égale à 5 nm.

Des exemples de matériaux barrière aux alcalins ou de noircissement seront décrits ultérieurement.

Par souci de simplicité, on peut ainsi privilégier des techniques de dépôts du matériau de grille et de surgrille et d'éventuelle sous grille directionnelles (et de préférence identiques). Les dépôts peuvent s'effectuer à la fois au travers des ouvertures et sur le masque.

Dans des modes de réalisation préférés de l'invention, on peut éventuellement avoir recours en outre à l'une et/ou à l'autre des dispositions suivantes :
- le dépôt du matériau de grille remplit à la fois une fraction des ouvertures du masque et couvre aussi la surface du masque,
- le dépôt du matériau de grille est un dépôt à pression atmosphérique, notamment par plasma, un dépôt sous vide, par pulvérisation cathodique, par évaporation.
- le dépôt du matériau de surgrille remplit à la fois une fraction des ouvertures du masque (et couvre la grille) et couvre aussi la surface du masque,
- le dépôt du matériau de surgrille est un dépôt à pression atmosphérique, notamment par plasma, un dépôt sous vide, par pulvérisation cathodique, par évaporation
- le dépôt du matériau de sousgrille remplit à la fois une fraction des ouvertures du masque et couvre aussi la surface du masque,
- le dépôt du matériau de sousgrille est un dépôt à pression atmosphérique, notamment par plasma, un dépôt sous vide, par puivérisation cathodique, par évaporation.

On peut ainsi choisir alors une ou des techniques de dépôts réalisables à température ambiante, et/ou simples (notamment plus simple qu'un dépôt catalytique faisant appel nécessairement à un catalyseur) et/ou donnant des dépôts denses.

Les méthodes de dépôt de la couche de grille ou de surgrille ou de sous grille peuvent être de type évaporation thermique sous vide, éventuellement assistée plasma (technique développée par le Fraunhofer de Dresde) : elles présentent des vitesses de dépôt supérieures à celles obtenues par magnétron.

De préférence, le dépôt de grille, le traitement thermique et le dépôt de surgrille (et de préférence de l'éventuel dépôt de sous grille) sont réalisés, dans la même enceinte de dépôt (de pulvérisation ou d'évaporation par exemple), sans rupture du vide.

Le substrat peut être teinté.

Le substrat recevant le masque à réseau peut être plan ou courbe.

Ses faces principales peuvent être rectangulaires, carrées ou même de toute autre forme (ronde, ovale, polygonale...). Ce substrat peut être de grande taille par exemple de surface supérieure à 0,02 m² voire même 0,5 m² ou 1 m².

Le substrat peut être substantiellement transparent, minéral ou en matière plastique comme du polycarbonate PC ou du polymétacrylate de méthyle PMMA ou encore le PET, du polyvinyle butyral PVB, polyuréthane PU, le polytétrafluoréthylène PTFE etc...

Le substrat recevant le masque peut comporter une sous-couche continue (notamment en couche de fond, la plus proche du substrat), susceptible d'être une barrière aux alcalins.

Elle protège de toute pollution le matériau de grille (pollutions qui peuvent entraîner des défauts mécaniques tels que des délaminations), dans le cas d'un dépôt électroconducteur (pour former électrode notamment), et préserve en outre sa conductivité électrique.

La couche de fond est robuste, facile et rapide à déposer suivant différentes techniques. On peut la déposer, par exemple par une technique de pyrolyse, notamment en phase gazeuse (technique souvent désignée par l'abréviation anglaise de C.V.D, pour « Chemical Vapor Deposition »). Cette technique est intéressante pour l'invention car des réglages appropriés des paramètres de dépôt permettent d'obtenir une couche très dense pour une barrière renforcée.

La couche de fond peut être éventuellement dopée à l'aluminium et/au bore pour rendre son dépôt sous vide plus stable. La couche de fond (monocouche ou multicouche, éventuellement dopée) peut être d'épaisseur entre 10 et 150 nm, encore plus préférentiellement entre 15 et50nm.

La couche de fond peut être de préférence :
- à base d'oxyde de silicium, d'oxycarbure de silicium, couche de formule générale Si0C,
- à base de nitrure de silicium, d'oxynitrure de silicium, d'oxycarbonitrure de silicium, couche de formule générale SiNOC, notamment SiN en particulier Si₃N₄.

On peut préférer tout particulièrement une couche de fond (essentiellement) en nitrure de silicium Si₃N₄, dopé ou non. Le nitrure de silicium est très rapide à déposer et forme une excellente barrière aux alcalins.

On peut procéder au nettoyage du réseau d'ouvertures à l'aide d'une source plasma à pression atmosphérique.

Le procédé utilise un masque fabriqué à partir du séchage d'une solution colloïdale, aussi la surface de dépôt du masque est nécessairement chimiquement stables avec l'eau ou d'autres solvants utilisés et en cas de solvant aqueux, la surface est de préférence hydrophile.

La surface pour le dépôt de la couche de masquage est filmogène notamment de préférence hydrophile si le solvant est aqueux, comme déjà vu. Il s'agit de la surface
- du substrat : verre, plastique (polyuréthane ou polycarbonate par exemple), plastique éventuellement traité (par plasma par exemple) pour être hydrophile, par exemple un PET traité, un PMMA traité,
- ou d'une sous-couche continue rajoutée, éventuellement fonctionnelle :
- couche hydrophile (couche de silice, par exemple sur plastique hydrophobe, tel que PET et PMMA), couche promotrice d'adhésion suffisante du masque,
- et/ou couche barrière aux alcalins, comme déjà décrite,
- et/ou (comme dernière couche) couche promotrice d'adhésion du matériau de grille,
- et/ou couche électroconductrice (transparente), et/ou couche décor, colorée ou opaque.

Entre la couche de masque et le substrat il peut y avoir plusieurs sous couches.

On choisit un Tg permettant de préférence de réaliser un traitement thermique à une température inférieure ou égale à 180°C, encore plus préférentiellement inférieure ou égale à 150°C.

De préférence, on choisit Tg compris entre 50°C et 120°C.

Le séchage peut conduire en une étape à l'élimination du solvant et à la formation des ouvertures.

Le masque obtenu est susceptible d'être aisément éliminé à l'aide d'eau pure, froide ou tiède, en particulier avec un solvant aqueux, sans avoir besoin de solutions fortement basiques ou de composés organiques potentiellement polluants.

En choisissant un Tg suffisamment élevé pour les nanoparticules de la solution, l'étape de séchage (comme de préférence l'étape de dépôt de la solution) peut être mise en oeuvre (sensiblement) à une température inférieure à 50°C, de préférence à température ambiante, typiquement entre 20° et 25°C.

L'écart entre la température de transition vitreuse Tg donné des particules de la solution et la température de séchage étant de préférence supérieur à 10°C voire 20°C.

L'étape de séchage de la couche de masquage peut être mise en oeuvre sensiblement à pression atmosphérique plutôt qu'un séchage sous vide par exemple.

On peut modifier les paramètres de séchage (paramètre de contrôle), notamment le degré d'humidité, la vitesse de séchage, pour ajuster la distance entre les ouvertures B, la taille des ouvertures A, et/ou le rapport B/A.

Plus l'humidité est élevée (toutes choses égales par ailleurs), plus A est faible.

Plus la température est élevée (toutes choses égales par ailleurs), plus B est élevé.

On peut déposer une solution (aqueuse ou non) de colloïdes par une technique de voies liquides usuelles.

On peut modifier d'autres paramètres de contrôle choisis parmi le coefficient de frottement entre les colloïdes compactées, notamment par nanotexturation du substrat et la surface du substrat, la taille des nanoparticules, et la concentration initiale en particules, la nature du solvant, l'épaisseur dépendant de la technique de dépôt, pour ajuster B, A, et/ou le rapport B/A.

Plus la concentration est élevée (toutes choses égales par ailleurs), plus B/A est faible.

Comme technique de voies humides, on a :
- le dépôt par rotation (connues en anglais sous l'appellation usuelle spin coating ,
- le dépôt par rideau (curtain),
- le dépôt par trempage (dip coating),
- le dépôt par pulvérisation (spray coating),
- le ruissellement (flow coating).

La solution peut être stable naturellement, avec des nanoparticules déjà formées, et de préférence ne contient pas (ou en quantité négligeable) d'élément réactif de type de précurseur de polymère.

Le solvant est de préférence à base d'eau, voire entièrement aqueux.

La solution de colloïdes comporte des nanoparticules polymériques (et de préférence avec un solvant à base d'eau voire entièrement aqueux)

On choisit par exemple des copolymères acryliques, des styrènes des polystyrènes, poly(meth)acrylates, des polyesters ou leurs mélanges.

La couche de masquage (avant séchage) peut être ainsi essentiellement constituée d'un empilement de nanoparticules colloidales (donc de nanoparticules d'un matériau insoluble dans le solvant) discernables, polymériques.

Les nanoparticules polymériques peuvent être de préférence constituées d'un polymère solide et insoluble dans de l'eau.

Par « essentiellement constituée », on entend que la couche de masquage peut éventuellement comprendre d'autres composés, à titre de traces, et qui n'influent pas sur les propriétés du masque (formation du réseau, retrait facile...).

La solution aqueuse colloïdale est de préférence constituée d'eau et des particules colloïdales polymériques, à l'exclusion donc de tout autre agent chimique (comme par exemple des pigments, des liants, des plastifiants...). De même, la dispersion aqueuse colloïdale est de préférence le seul composé utilisé pour former le masque.

Le masque à réseau (après séchage) peut être ainsi essentiellement constitué d'un empilement de nanoparticules, de préférence polymériques, discernables. Les nanoparticules polymériques sont constituées d'un polymère solide et insoluble dans de l'eau.

La solution peut comporter cumulativement, des nanoparticules minérales, de préférence de la silice, de l'alumine, de l'oxyde de fer.

De préférence, l'enlèvement du masque est réalisé par voie liquide, par un solvant inerte pour la grille, par exemple à l'eau, acétone, alcool, (éventuellement à chaud et/ou assisté par ultrasons).

On peut par ailleurs procéder à un nettoyage du réseau d'ouvertures préalablement à l'élaboration du dépôt du matériau de grille.

L'invention porte aussi sur un substrat, notamment transparent, porteur d'une grille revêtue d'une surgrille formée à partir du procédé de fabrication déjà défini précédemment.

La différence entre la transmission lumineuse du substrat avec la grille et celle du substrat avec la grille revêtue est de préférence inférieure ou égale à 25%, encore plus préférentiellement à 10%.

La surgrille comprend une couche de protection contre la corrosion, couvrante et entourant la grille, en particulier pour une surgrille métallique (argent, aluminium, cuivre...).

Comme matériau(x) de surcouche on peut choisir :
- nitrure de silicium, silice (ne modifiant pas la transmission lumineuse),
- carboxynitrure,
- un métal moins oxydable que le matériau de grille, par exemple pour l'aluminium au choix : Cr, Mo, NiCr.

A titre illustratif, pour une protection contre la corrosion suffisante on choisit :
- une épaisseur de surgrille supérieure ou égale à 10 nm, de préférence inférieure à la moitié de l'épaisseur de la grille, inférieure à égale à 100 nm,
- une largeur de la surgrille à partir du bord de grille supérieure ou égale à A'/2, et inférieure ou égale à 3A', de préférence à 2A',

Et de préférence on rajoute une sous couche de protection contre la corrosion, en matériau de surgrille, de préférence d'épaisseur inférieure à égale à 50 nm.

L'encapsulation est ainsi complète.

La surgrille peut comprendre une couche de noircissement, avec une pureté en réflexion Pe inférieure à 10% et une longueur d'onde dominante en réflexion autour du bleu (autour de 480 nm).

Cela peut en particulier servir pour noicir du cuivre, de longueur d'onde dominante en réflexion autour du rouge (autour de 600 nm).

Comme matériau(x) de surcouche on peut choisir Cr, NiCr.

Cette réduction de la réflexion lumineuse (passant du rouge au bleu) améliore l'esthétique.

A titre illustratif, pour un noircissement suffisant on choisit :
- une épaisseur de surgrille supérieure ou égale à 20 nm, de préférence inférieure à la moitié de l'épaisseur de la grille
- une largeur de la surgrille à partir du bord de grille supérieure ou égale à A'/2, et inférieure ou égale à 2A',de préférence à 1,5A'.

Et de préférence on rajoute une sous couche de noircissement, notamment en matériau de surgrille, de préférence d'épaisseur inférieure à égale à 50 nm.

En observant la grille en incidence rasante, la grille apparaît noire sur toutes les faces.

Le matériau de surgrille peut aussi être en ledit matériau de grille. Le brin est ainsi plus épais au centre que sur les bords. Cela permet en outre d'augmenter la conductivité électrique.

La surgrille peut permettre une compatibilité avec les étapes ultérieures de fabrication d'un produit.

Par exemple, une surgrille peut être une couche barrière de diffusion de métal de grille, par exemple couche barrière en aluminium ou molybdène, sur une grille en cuivre. Le cuivre pollue toute couche organique par exemple celle(s) d'un dispositif OLED.

Par exemple une surgrille peut être en oxyde (métallique ...), pour faciliter le feuilletage d'une grille métallique oxydable (cuivre etc) de compatibilité insuffisante avec l'intercalaire (PVB notamment).

Par exemple la surgrille peut comprendre une couche d'arrêt de gravure chimique, isolante ou conductrice si nécessaire.

La grille peut être déposée sur une sous couche, par exemple hydrophile et/ou promotrice d'adhésion et/ou barrière et/ou décor comme déjà indiqué.

La grille (et sa surgrille, sa sous grille) peut être irrégulière, c'est-à-dire un réseau de brins bidimensionnel et maillé, avec des mailles (motifs fermés délimités par les brins), aléatoires, apériodiques.

La grille (ou sa surgrille) peut présenter l'une et/ou les caractéristiques suivantes :
- un rapport espace (moyen) entre les brins (B') sur la largeur (moyenne) submillimétrique des brins (A') compris entre 7 et 40,
- les motifs de la grille sont aléatoires (apériodiques), de forme et/ou taille diverses,
- des mailles sont à trois et/ou quatre et/ou cinq côtés, par exemple en majorité quatre côtés,
- la grille présente une structure apériodique (ou aléatoire) dans au moins une direction, de préférence dans deux directions,
- pour la majorité voire toutes les mailles, dans une région donnée ou sur toute la surface, l'écart entre la plus grande dimension caractéristique de maille et la plus petite dimension caractéristique de maille inférieure à 2,
- pour la majorité voire toutes les mailles, l'angle entre deux côtés adjacents d'une maille peut être compris entre 60° et 110°, notamment entre 80° et 100°,
- l'écart entre la largeur maximale de brins et la largeur minimale de brins est inférieur à 4, voire inférieur ou égal à 2, dans une région donnée de grille, voire sur la majorité ou toute la surface,
- l'écart entre la dimension maximale de maille (espace ente brins formant une maille) et la dimension minimale de maille est inférieur à 4, voire inférieure ou égal à 2, dans une région donnée de grille, voire sur la majorité ou même toute la surface,
- le taux de maille non fermé et/ou de segment de brin coupé (« en aveugle »), est inférieure à 5%, voire inférieure ou égale 2%, dans une région donnée de grille, voire sur la majorité ou toute la surface, soit une rupture de réseau limité voir quasi nulle,
- en majorité, les bords de brins sont d'écartement constant, notamment sensiblement linéaires, parallèles, à l'échelle de 10 µm (par exemple observé au microscope optique avec un grossissement de 200).

La grille selon l'invention peut avoir des propriétés électriques isotropes.

La grille irrégulière selon l'invention peut ne diffracter pas une lumière ponctuelle.

L'épaisseur des brins de la grille peut être sensiblement constante dans l'épaisseur, ou être plus large à la base.

La grille (et sa surgrille) peut comporter un réseau principal avec des brins (éventuellement approximativement parallèles) et un réseau secondaire de brins (éventuellement approximativement perpendiculaires au réseau parallèle).

La grille peut être déposée sur au moins une portion de surface du substrat, notamment à fonction verrière, en matière plastique ou minérale, comme déjà indiqué.

La grille électroconductrice (ou sa surgrille) peut présenter une résistance carré comprise entre 0,1 et 30 Ohm/carré. Avantageusement, la grille électroconductrice selon l'invention peut présenter une résistance par carré inférieure ou égale à 5 Ohm/carré, voire inférieure ou égale à 1 Ohm/carré, voire même 0,5 Ohm/carré notamment pour une épaisseur de grille supérieure ou égale à 1 µm, et de préférence inférieure à 10 µm voire inférieure ou égale à 5 µm.

Le rapport B'/A' peut être différent, par exemple au moins double, dans une première région de grille et dans une deuxième région de grille. Les première et deuxième régions peuvent être de forme distincte ou égale et/ou de taille distincte ou égale.

Avec un rapport ouverture de la maille /taille des brins variable, il est possible de ce fait de créer des zones avec :
- un gradient de transmission lumineuse,
- un gradient de puissance électrique (application au chauffage, dégivrage, réalisation de flux thermique homogène sur des surfaces non rectangulaire.

La transmission lumineuse de la grille (et sa surgrille) dépend du rapport B/A entre la distance moyenne entre les brins B sur la largeur moyenne des brins A.

De préférence, le rapport B/A est compris entre 5 et 15 encore plus préférentiellement de l'ordre de 10 pour conserver aisément la transparence et faciliter la fabrication. Par exemple, B et A valant respectivement environ 50 µm et 5 µm.

En particulier, on choisit une largeur moyenne de brins A entre 100 nm et 30 µm, préférentiellement inférieure ou égale 10 µm, voire 5 µm pour limiter leur visibilité et supérieure ou égale à 1 µm pour faciliter la fabrication et pour conserver aisément une haute conductivité et une transparence.

En particulier, on peut en outre choisir une distance moyenne entre brins B' supérieure à A', entre 5 µm et 300 µm, voire entre 20 et 100 µm, pour conserver aisément la transparence.

L'épaisseur des brins peut être entre 100 nm et 5 µm, notamment micronique, encore plus préférentiellement de 0,5 à 3 µm pour conserver aisément une transparence et une haute conductivité.

La grille selon l'invention peut être sur une grande surface par exemple une surface supérieure ou égale à 0,02 m² voire même supérieure ou égale à 0,5 m² ou à 1 m².

En faisant varier le rapport B'/A' (espace entre les brins B' sur la largeur des brins A' taille des brins) on obtient pour la grille des valeurs de flou comprises entre 1 et 20 %.

Le substrat peut être substantiellement transparent, comme déjà vu. Le substrat peut être à fonction verrière lorsqu'il est substantiellement transparent, et qu'il est à base de minéraux (un verre silicosodocalcique par exemple) ou qu'il est à base de matière plastique (comme du polycarbonate PC ou du polymétacrylate de méthyle PMMA),

Pour transmettre un rayonnement UV, le substrat peut être choisi de préférence parmi le quartz, la silice, le fluorure de magnésium (MgF₂) ou de calcium (CaF₂), un verre borosilicate, un verre avec moins de 0,05% de Fe₂O₃.

A titre d'exemples pour des épaisseurs de 3 mm :
- les fluorures de magnésium ou de calcium transmettent à plus de 80% voire 90% sur toute la gamme des UV c'est-à-dire les UVA (entre 315 et 380 nm), les UVB (entre 280 et 315 nm), les UVC (entre 200 et 280 nm), ou les VUV (entre environ 10 et 200 nm),
- le quartz et certaines silices haute pureté transmettent à plus de 80% voire 90% sur toute la gamme des UVA, UVB et UVC,
- le verre borosilicate, comme le borofloat de Schott, transmet à plus de 70% sur toute la gamme des UVA,
- les verres silicosodocalcique avec moins de 0,05% de Fe III ou de Fe₂O₃, notamment le verre Diamant de Saint-Gobain, le verre Optiwhite de Pilkington, le verre B270 de Schott, transmettent à plus de 70% voire 80% sur toute la gamme des UVA.

Toutefois, un verre silicosodocalcique, tel que le verre Planilux vendu par la société Saint-Gobain, présente une transmission supérieure à 80% au delà de 360 nm ce qui peut suffire pour certaines réalisations et certaines applications.

Le substrat peut aussi être choisi pour être transparent dans une gamme donnée d'infrarouge, par exemple entre 1 µm et 5 µm. IL s'agit par exemple du saphir.

La transmission lumineuse (globale) du substrat porteur de la grille revêtue peut être supérieure ou égale à 50%, encore plus préférentiellement supérieure ou égale à 70%, notamment est comprise entre 70% à 86 %.

La transmission (globale) dans une gamme d'IR donnée, par exemple entre 1 et 5 µm, du substrat porteur de la grille revêtue peut être supérieure ou égale à 50%, encore plus préférentiellement supérieure ou égale à 70%, notamment est comprise entre 70% à 86%. Les applications visées sont par exemple des vitrages chauffants avec système à vision infrarouge, notamment pour une vision nocturne.

La transmission (globale) dans une gamme d'UV donnée, du substrat porteur de la grille revêtue peut être supérieure ou égale à 50%, encore plus préférentiellement supérieure ou égale à 70%, notamment est comprise entre 70 % à 86 %.

Un vitrage multiple, feuilleté (intercalaire de feuilletage de type EVA, PU, PVB...) peut incorporer le substrat avec la grille revêtue selon l'invention.

La grille revêtue selon l'invention peut être utilisée notamment comme électrode inférieure (la plus proche du substrat) pour un dispositif électroluminescent organique (OLED en anglais) notamment à émission par l'arrière (« bottom emission » en anglais) ou à émission par l'arrière et l'avant.

Selon encore un autre aspect de l'invention, elle vise l'utilisation d'une grille telle que précédemment décrite en tant que
- couche active (électrode mono ou multicouche) dans un dispositif électrochimique, et/ou électrocommandable et à propriétés optiques et/ou énergétiques variables, par exemple un dispositif à cristaux liquides ou un dispositif photovoltaïque, ou encore un dispositif électroluminescent organique ou inorganique (« TFEL » etc), une lampe notamment plane, une lampe UV éventuellement plane,
- grille chauffante d'un dispositif chauffant, pour véhicule (pare-brise chauffant, lunette arrière chauffante) ou pour des applications électroménager, de type radiateur, sèche serviette, enceinte réfrigérée, pour une action de dégivrage, anti-condensation, antibuée, ....
- grille de blindage électromagnétique,
- ou tout autre dispositif nécessitant une grille (éventuellement (semi) transparente) électroconductrice.

Pour rappel, dans les systèmes électrochromes, on compte les " tout solide " (les « tout solide » sont définis, au sens de l'invention pour des empilements de couches pour lesquels toutes les couches sont de nature inorganique) ou les " tout polymère "(les « tout polymère » sont définis, au sens de l'invention pour des empilements de couches pour lesquels toutes les couches sont de nature organique), ou encore des électrochromes mixtes ou hydrides (les couches de l'empilement sont de nature organique et de nature inorganique) ou encore aux systèmes à cristaux liquides ou viologènes.

Pour rappel, les lampes à décharge comportent avec luminophore(s) comme élément actif. Les lampes planes en particulier comportent deux substrats en verre maintenus avec un faible écartement l'un par rapport à l'autre, généralement inférieur à quelques millimètres, et scellés hermétiquement de manière à renfermer un gaz sous pression réduite dans lequel une décharge électrique produit un rayonnement généralement dans le domaine ultraviolet qui excite un luminophore émettant alors de la lumière visible.

Les lampes planes UV peuvent avoir la même structure on choisit naturellement pour au moins l'une des parois un matériau transmettant les UV (comme déjà décrit). Le rayonnement UV est directement produit par le gaz plasmagène et/ou par un luminophore additionnel adapté.

Comme exemples de lampes planes UV on peut se référer aux brevets WO2006/090086, WO2007/042689, WO2007/023237 WO2008/023124 incorporés par référence.

La décharge entre les électrodes (anode et cathode) peut être non coplanaire (« plan plan »), avec anode et cathode respectivement associées aux substrats, par une face ou dans l'épaisseur, (toutes deux internes ou externes, l'une interne et l'autre externe, l'une au moins dans le substrat...) par exemple telle que décrite dans les brevets WO2004/015739, WO2006/090086, WO2008/023124 incorporés par référence.

Dans les lampes UV et les lampes planes, la décharge entre les électrodes (anode et cathode) peut être coplanaire (anode et cathode dans un même plan, sur un même substrat) comme décrit dans le brevet WO2007/023237 incorporé par référence.

Il peut s'agir d'un autre type système éclairant, à savoir un dispositif électroluminescent inorganique, l'élément actif étant une couche électroluminescente inorganique à base de phosphore dopé, par exemple choisi parmi : ZnS : Cu, Cl ; ZnS : Cu, Al ; ZnS : Cu, Cl, Mn, ou encore CaS, SrS. Cette couche est de préférence séparée des électrodes par des couches isolantes. Des exemples de tels vitrages sont décrits dans le document EP1 553 153 A (avec les matériaux par exemple dans le tableau 6).

Un vitrage à cristaux liquides peut servir de vitrage à diffusion lumineuse variable. Il est basé sur l'utilisation d'un film placé entre deux couches conductrices et à base d'une matière polymérique dans laquelle sont dispersées des gouttelettes de cristaux liquides, notamment nématiques à anisotropie diélectrique positive. Les cristaux liquides, quand le film est mis sous tension, s'orientent selon un axe privilégié, ce qui autorise la vision. Hors tension, en l'absence d'alignement des cristaux, le film devient diffusant et empêche la vision. Des exemples de tels films sont décrits notamment dans les brevets européen EP0238164 et américains US4435047, US4806922, US4732456. Ce type de film, une fois feuilleté et incorporé entre deux substrats en verre, est commercialisé par la société SAINT-GOBAIN GLASS sous la dénomination commerciale Privalite.

On peut en fait utiliser tous les éléments à cristaux liquides connus sous les termes de « NCAP » (Nematic Curvilinearly Aligned Phases en anglais) ou « PDLC » (Polymer Dispersed Liquid Cristal en anglais) ou « CLC » (Cholesteric Liquid Cristal en anglais).

Ceux-ci peuvent en outre contenir des colorants dichroïques, notamment en solution dans les gouttelettes de cristaux liquides. On peut alors conjointement moduler la diffusion lumineuse et l'absorption lumineuse des systèmes.

On peut également utiliser, par exemple, les gels à base de cristaux liquides cholestériques contenant une faible quantité de polymère réticulé, comme ceux décrits dans le brevet WO-92/19695.

L'invention concerne également l'incorporation de grille telle qu'obtenue à partir de l'élaboration du masque précédemment décrit dans des vitrages, fonctionnant en transmission.

Le terme « vitrage » est à comprendre au sens large et englobe tout matériau essentiellement transparent, à fonction verrière, en verre et/ou en matériau polymère (comme du polycarbonate PC ou du polymétacrylate de méthyle PMMA). Les substrats porteurs et/ou contre-substrats, c'est-à-dire les substrats encadrant le système actif, peuvent être rigides, flexibles ou semi-flexibles.

L'invention concerne également les diverses applications que l'on peut trouver à ces dispositifs, vitrages ou miroirs : il peut s'agir de faire des vitrages pour bâtiment, notamment des vitrages extérieurs, des cloisons internes ou des portes vitrées). Il peut aussi s'agir de fenêtres, toits ou cloisons internes de moyens de transport comme des trains, avions, voitures, bateaux, engin de chantier. Il peut aussi s'agir d'écrans de visualisation ou d'affichage, comme des écrans de projection, des écrans de télévision ou d'ordinateur, des écrans tactiles, des surfaces éclairantes, des vitrages chauffants.

L'invention sera maintenant décrite plus en détails à l'aide d'exemples non limitatifs et de figures :
- les figures 1 et 2 représentent de manière schématique les étapes principales du procédé de fabrication de la grille électroconductrice submillimétrique revêtue d'une surgrille selon l'invention,
- les figures 3 à 5 représentent de manière schématique les étapes principales du procédé de fabrication de la grille revêtue selon l'invention, dans une variante,
- les figures 6 à 8b représentent des exemples de masques utilisés dans le procédé selon l'invention,
- la figure 9 est une vue MEB illustrant le profil du masque à réseau,
- les figures 10 et 11 représentent des masques à réseau avec des fronts de séchage différent,
- les figures 12a à 13b illustrent l'influence du traitement thermique sur le masque à réseau.

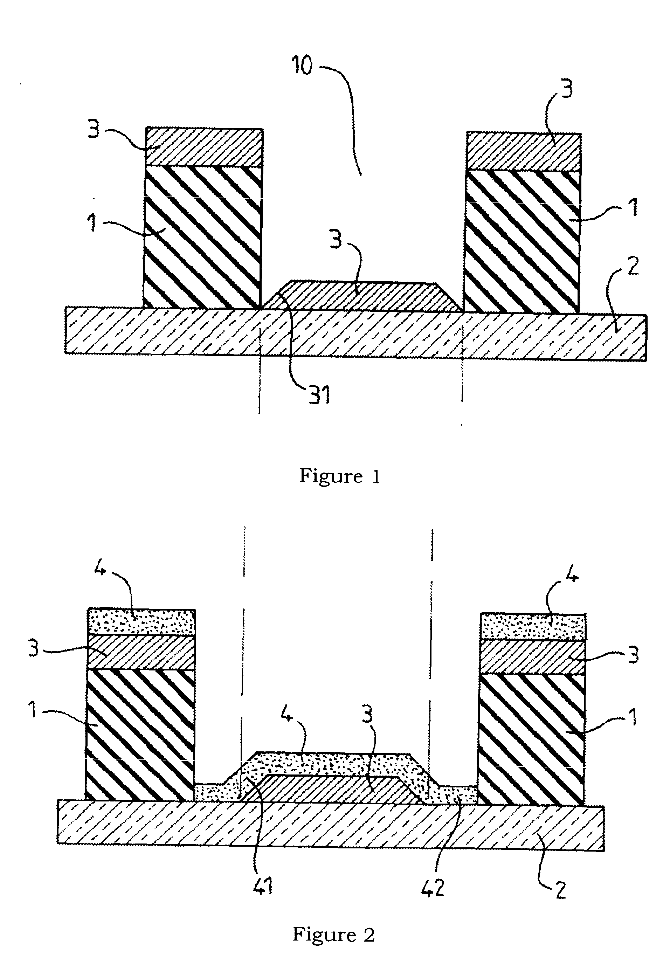

Les figures 1 et 2 représentent de manière schématique les étapes principales du procédé de fabrication de la grille électroconductrice submillimétrique revêtue d'une surgrille selon l'invention

Le procédé de fabrication de la grille revêtue comprend :
- la réalisation d'un masque à ouvertures submillimétriques 1, dit masque à réseau, sur la face principale d'un substrat 2, incluant :
- le dépôt d'une couche de masquage à partir d'une solution de nanoparticules colloïdales polymériques stabilisées et dispersées dans un solvant, les particules polymériques ayant une température de transition vitreuse Tg donnée,
- le séchage de la couche de masquage à une température inférieure à ladite température Tg jusqu'à l'obtention du masque 1 à réseau d'ouvertures 10, avec des bords des zones du masque sensiblement droits, les ouvertures séparant des zones du masque,
- la formation de la grille électrocondutrice 3 à partir du masque à réseau comportant un dépôt par PVD d'au moins un matériau électroconducteur, dit de grille 3, jusqu'à remplir une fraction de la profondeur des ouvertures, et couvrant aussi la surface des zones de masque
- un traitement thermique de la couche de masquage avec le matériau de grille à une température supérieure ou égale à 0,8 fois Tg, conduisant à un rétrécissant des zones du masque, créant ainsi un espace entre les bords de zones de masque et les bords latéraux de la grille,
- un dépôt d'une couche, dite surcouche, en un matériau dit de surcouche 4, sur la grille et dans l'espace entre les bords de zones de masque et les bords latéraux de la grille, et couvrant aussi la surface des zones de masque,
- un enlèvement de la couche de masquage, jusqu'à laisser révéler la grille revêtue de la surgrille.

Les bords des zones de masque étant droits, la couche formant la grille 3 présente des bords latéraux 31 inclinés comme montré en figure 1.

Les bords des zones de masque étant plus écartés après le traitement thermique, la couche formant la surgrille 4 recouvre les bords latéraux 31 inclinés (avec des bords latéraux conformes, également inclinés 41) et s'étend jusqu'aux bords de zone de masque comme montré en figure 2.

Cette surgrille couvrant trois faces de la grille 3 peut servir de couche de protection contre la corrosion, de protection de la grille en vue d'étapes délicates de procédé, de noircissement.

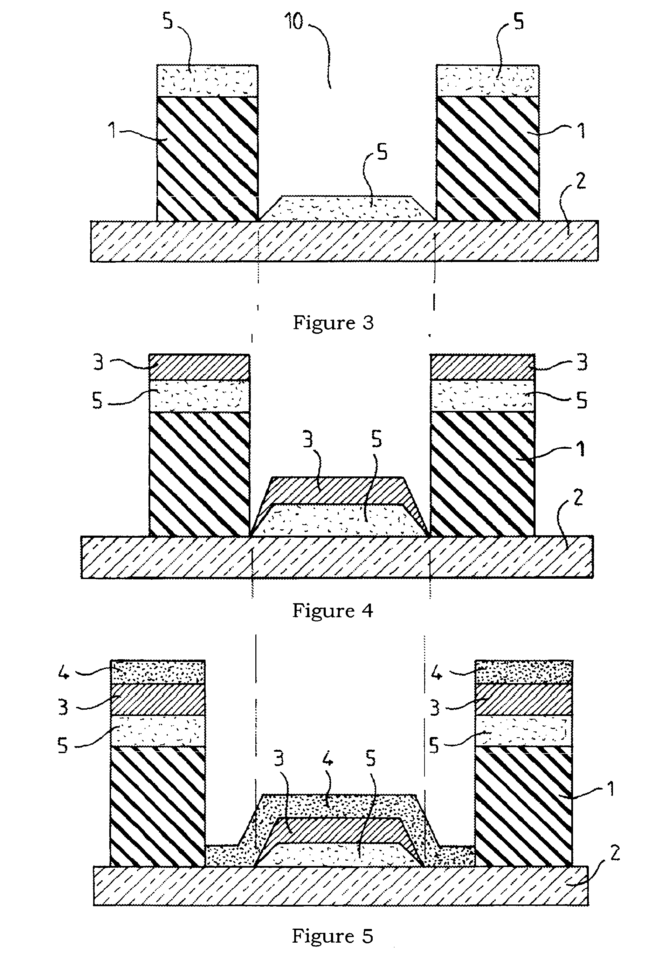

Les figures 3 à 5 représentent de manière schématique les étapes principales du procédé de fabrication de la grille électroconductrice submillimétrique revêtue d'une surgrille selon l'invention, dans une variante.

Dans cette variante le procédé diffère en ce qu'il comprend le dépôt d'une couche, dite sous grille 5, au travers les ouvertures 10 et sous la grille 4, (et couvrant aussi la surface des zones de masque),. notamment une sous-grille d'adhésion de la grille, une sous-grille barrière aux alcalins. une sous grille de noircissement.

La sous grille et la surgrille couvrant les quatre faces de la grille 3 comme en figure 5.

Nous allons maintenant détailler les principales étapes de fabrication une à une, par ordre de succession

### FABRICATION DU MASQUE A RESEAU

Sur une portion de substrat par exemple à fonction verrière, par exemple plan et minéral, on dépose par une technique de voies humides, par « spin coating » une émulsion simple de particules colloïdales à base de copolymère acrylique stabilisées dans de l'eau selon une concentration massique de 40 %, un pH de 5,1, de viscosité égale à 15 mPa.s. Les particules colloïdales présentent une dimension caractéristique comprise de 80 à 100 nm et sont commercialisées sous la société DSM sous la marque Neocryl XK 52® et sont de Tg égale à 115°C.

On procède alors au séchage de la couche incorporant les particules colloïdales de manière à faire évaporer le solvant et à former les ouvertures. Ce séchage peut être réalisé par tout procédé approprié et à une température inférieure à Tg (séchage à l'air chaud ...), par exemple à température ambiante.

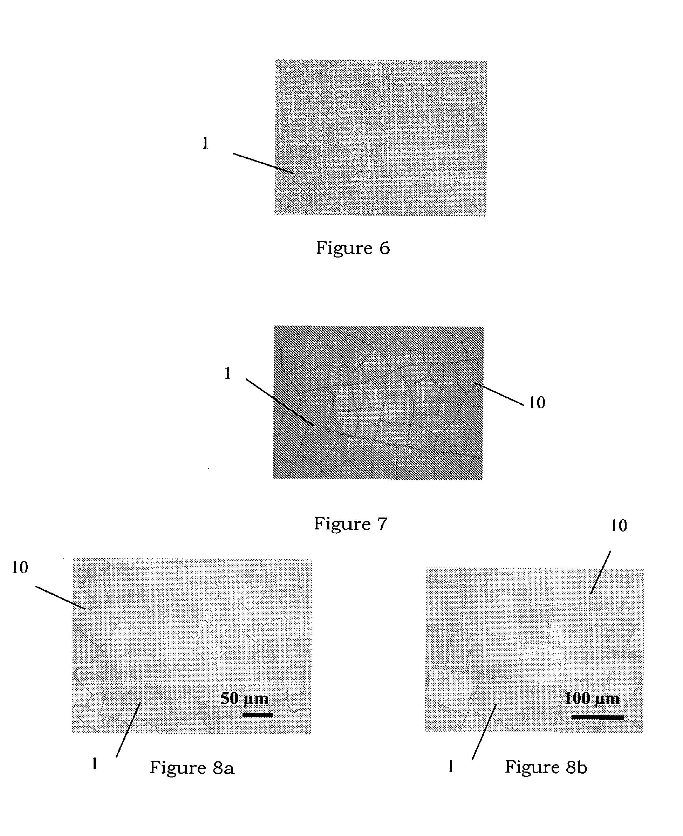

Lors de cette étape de séchage le système s'auto-arrange forme un masque à réseau 1 comportant un réseau d'ouvertures 10 et des zones de masque. Il décrit des motifs dont des exemples de réalisation sont représentées au niveau des figures 6 et 7 (vues (400 µm x 500 µm)).

On obtient un masque à réseau 1 stable sans avoir recours à un recuit avec une structure caractérisée par la largeur (moyenne) d'ouverture dénommé par la suite A et l'espace (moyen) entre les ouvertures dénommé par la suite B. Ce masque stabilisé sera par la suite défini par le rapport B/A.

On obtient un réseau bidimensionnel d'ouvertures, maillé avec peu de rupture de mailles (ouverture bouchée).

On a évalué l'influence de la température du séchage. Un séchage à 10°C sous 20% HR conduit à une maille de 80 µm (figure 8a), tandis qu'un séchage à 30 °C sous 20% HR conduit à une maille de 130 µm (figure 8b).

On a évalué l'influence des conditions de séchage, notamment de degré d'humidité. La couche à base de XK52 est cette fois déposée par flow coating (ruissellement) ce qui donne une variation d'épaisseur entre le bas et le haut de l'échantillon (de 10 µm à 20 µm) conduisant à une variation de taille de maille. Plus l'humidité est élevé, plus B est petit.

| Séchage | Position | Taille de maille B (µm) |
|---|---|---|
| 10°C - 20% humidité | Haut | 65 |
| 10°C - 20% humidité | Bas | 80 |
| 10°C - 80% humidité | Haut | 45 |
| 10°C - 80% humidité | Bas | 30 |
| 30°C - 20% humidité | Haut | 60 |
| 30°C - 20% humidité | Bas | 130 |
| 30°C - 80% humidité | Haut | 20 |
| 30°C - 80% humidité | Bas | 45 |

On modifie ce rapport B/A également en adaptant par exemple le coefficient de frottement entre les colloïdes compactées et la surface du substrat, ou encore la taille des nanoparticules, voire aussi la vitesse d'évaporation, ou la concentration initiale en particules, ou la nature du solvant, ou l'épaisseur dépendant de la technique de dépôt....

Afin d'illustrer ces diverses possibilités, on donne ci après un plan d'expériences avec 2 concentrations de la solution de colloïdes (C₀ et 0.5 x C₀) et différentes épaisseurs déposées en réglant la vitesse de remontée du DIP. On remarque que l'on peut changer le rapport B/A en changeant la concentration et/ou la vitesse de séchage. Les résultats sont reportés dans le tableau suivant :

| Concentration massique | Vitesse de remontée du DIP (cm/min) | B : Espace entre les ouvertures (µm) | A : Largeur des ouvertures (µm) | rapport B/A |
|---|---|---|---|---|
| 20% | 5 | 25 | 3 | 8,4 |
| 20% | 10 | 7 | 1 | 7 |
| 20% | 30 | 8 | 1 | 8 |
| 20% | 60 | 13 | 1,5 | 8.6 |
| 40 % | 5 | 50 | 4 | 12,5 |
| 40 % | 10 | 40 | 3,5 | 11,4 |
| 40 % | 30 | 22 | 2 | 11 |
| 40 % | 60 | 25 | 2,2 | 11,4 |

On a déposé la solution de colloïdes à la concentration de C₀=40% en utilisant des tire-films de différentes épaisseurs. Ces expériences montrent que l'on peut varier la taille des brins et la distance entre les brins en ajustant l'épaisseur initiale de la couche de colloïdes.

| Epaisseur déposée par le tire-film (µm) | % massique | B : Espace entre les ouvertures (µm) | A : Largeur des ouvertures (µm) | rapport B/A |
|---|---|---|---|---|
| 30 | 40 | 20 | 2 | 10 |
| 60 | 40 | 55 | 5 | 11 |
| 90 | 40 | 80 | 7 | 11,4 |
| 120 | 40 | 110 | 10 | 11,1 |
| 180 | 40 | 200 | 18 | 11,1 |
| 250 | 40 | 350 | 30 | 11,6 |

On a enfin modifié la rugosité de la surface du substrat en gravant par plasma atmosphérique la surface du verre via un masque de nodules d'Ag. Cette rugosité est de l'ordre de grandeur de la taille des zones de contact avec les colloïdes ce qui augmente ie coefficient de frottement de ces colloïdes avec le substrat. Le tableau suivant montre l'effet du changement de coefficient de frottement sur le ratio B/A et la morphologie du masque. Il apparaît que l'on obtient des tailles de mailles plus faibles à épaisseur initiale identique et un rapport B/A qui augmente.

| Traitement de nanotexturation | Vitesse de remontée du DIP (cm/min) | B : Espace entre les ouvertures (µm) | A : Largeur des ouvertures (µm) | Rapport B/A |
|---|---|---|---|---|
| Oui | 5 | 38 | 2 | 19 |
| Oui | 10 | 30 | 1,75 | 17,2 |
| Oui | 30 | 17 | 1 | 17 |
| Oui | 60 | 19 | 1 | 17,4 |
| Référence | 5 | 50 | 4 | 12,5 |
| Référence | 10 | 40 | 3,5 | 11,4 |
| Référence | 30 | 22 | 2 | 11 |
| Référence | 60 | 25 | 2,2 | 11,4 |

Dans un autre exemple de réalisation, on donne ci-après les paramètres dimensionnels de réseau d'ouvertures obtenus par spin coating d'une même émulsion contenant des particules colloïdales précédemment décrites. Les différentes vitesses de rotation de l'appareil de « spin coating » modifient la structure du masque.

| Vitesse de rotation (tr/min.) | B : Espace entre les ouvertures (µm) | A : Largeur des ouvertures (µm) | Rapport B/A |
|---|---|---|---|
| 200 | 40 | 2 | 20 |
| 400 | 30 | 2 | 15 |
| 700 | 20 | 1 | 20 |
| 1000 | 10 | 0,5 | 20 |

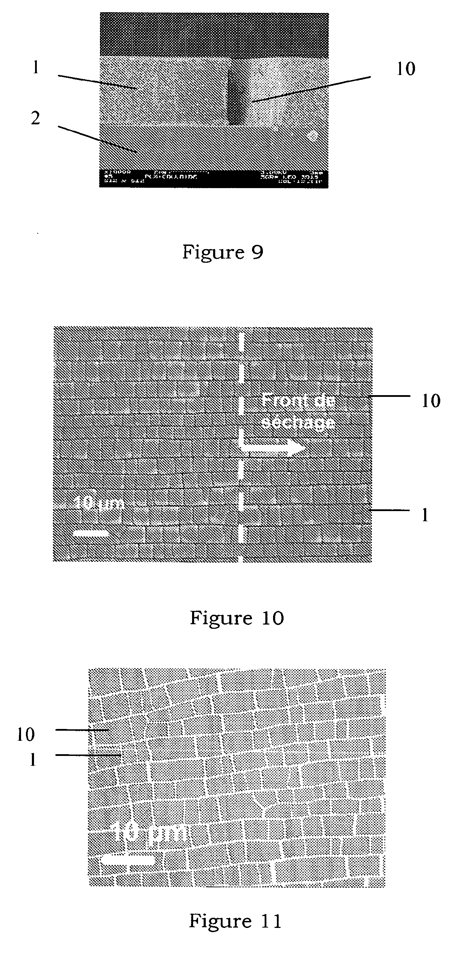

L'effet de la propagation (cf. figures 10 et 11) d'un front de séchage sur la morphologie du masque a été étudiée. La présence d'un front de séchage permet de créer un réseau d'ouvertures approximativement parallèles et dont la direction est perpendiculaire à ce front de séchage. Il existe d'autre part un réseau secondaire d'ouvertures approximativement perpendiculaires au réseau parallèles dont la localisation et la distance entre ouvertures sont aléatoires.

A ce stade de la mise en oeuvre du procédé, on obtient un masque à réseau 1.

Une étude morphologique du masque a montré que les ouvertures présentent un profil d'ouverture droit. On pourra se reporter à la figure 9 qui est une vue transverse du masque 1 sur le substrat 2 obtenue au MEB.

Le profil des ouvertures 10 (autrement dit des zones de masques) représenté en figure 9 présente un avantage certain pour :
- déposer une forte épaisseur de matériaux,
- conserver un motif, en particulier de forte épaisseur, conforme au masque après avoir retiré celui-ci.

Le masque ainsi obtenu peut être utilisé tel que ou modifié par différents post traitements. Les inventeurs ont découvert par ailleurs que l'utilisation d'une source plasma en tant que source de nettoyage des particules organiques situées en fond d'ouverture permettait ultérieurement d'améliorer l'adhésion du matériau servant à la grille.

Selon cette configuration, il n'y pas de particules colloïdales en fond des ouvertures, il y aura donc une adhésion maximale du matériau que l'on prévoit d'apporter de manière à combler l'ouverture (cela sera décrit en détail postérieurement dans le texte) avec le substrat à fonction verrière.

A titre d'exemple de réalisation, un nettoyage à l'aide d'une source plasma à pression atmosphérique, à plasma soufflé à base d'un mélange d'oxygène et d'hélium permet à la fois l'amélioration de l'adhésion du matériau déposé au fond des ouvertures et l'élargissement des ouvertures. On pourra utiliser une source plasma de marque « ATOMFLOW » commercialisée par la société Surfx.

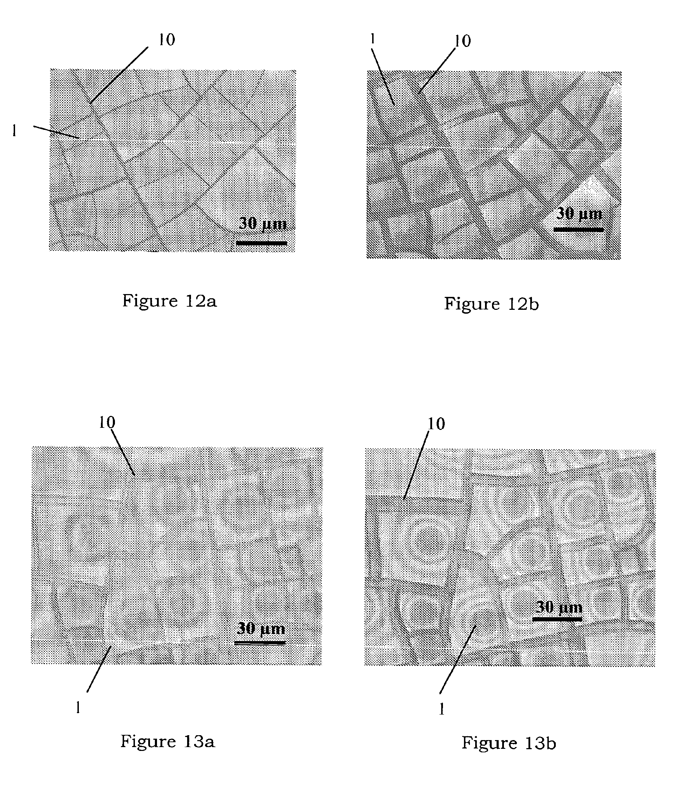

Dans un autre mode de réalisation, on dépose une émulsion simple de particules colloïdales à base de copolymère acrylique stabilisées dans de l'eau selon une concentration massique de 50 %, un pH de 3, de viscosité égale à 200 mPa.s. Les particules colloïdales présentent une dimension caractéristique de 118 nm environ et sont commercialisées sous la société DSM sous la marque Neocryl XK 38® et sont de Tg égale à 71°C. Le réseau obtenu est montré en figure 12a. L'espace entre les ouvertures est entre 50 et 100 µm et la gamme de largeurs des ouvertures est entre 3 et 10 µm.

### FABRICATION DE LA GRILLE

A partir du masque selon l'invention, on réalise une grille électroconductrice. Pour ce faire, on procède au dépôt, au travers du masque, d'un matériau électroconducteur électriquement tel que l'aluminium, l'argent, le cuivre, le nickel, le chrome, les alliages de ces métaux, les oxydes conducteurs choisis notamment parmi l'ITO, IZO, ZnO : Al ; ZnO : Ga ZnO :B ; SnO2 : F ; SnO2 : Sb. On procède au dépôt du matériau à l'intérieur du réseau d'ouvertures de manière à venir remplir les ouvertures, le remplissage s'effectuant selon une épaisseur par exemple de l'ordre d'1/2 hauteur de masque.

On dépose par exemple une couche d'Ag d'une épaisseur de 300 nm par magnétron.

Cette phase de dépôt peut être réalisée par exemple par pulvérisation magnétron.

### TRAITEMENT THERMIQUE

On a évalué l'influence d'un traitement sur les paramètres du réseau.

Dans un premier exemple, on a comparé l'évolution du masque déposé avec du XK38 avant traitement thermique (figure 12a) et après (figure 12b). Les résultats sont compilés dans le tableau suivant :

| Ech XK38 | Traitement thermique (température, durée) | Gamme des tailles d'ouvertures (µm) | Gamme des distances entre ouvertures (µm) |
|---|---|---|---|
| Référence | non | 50-100 | 3-10 |
| Echantillon recuit | 100°C 5 min | 50-100 | 6-20 |
| Echantillon recuit | 100°C 15 min | 50-100 | 10-25 |

Par compaction la largeur des ouvertures double, voire triple comme montré en figure 12b (échantillon traité à 100°C pendant 15 min).

Dans un deuxième exemple on a comparé l'évolution du masque déposé (avec un XK38) avant traitement thermique (cf. figure 13a) et après traitement thermique à 140°C pendant 15 minutes (cf. figure 13b). On observe une augmentation plus importante de la largeur des ouvertures.

### FABRICATION DE LA SURGRILLE

Après traitement thermique, on dépose la surgrille au travers des ouvertures.

Dans un exemple on dépose on dépose le même matériau pour la surgrille que pour la grille, à avoir l'argent. Le masque a été réalisé à partir de XK52.

Un échantillon de référence est une grille d'argent n'ayant pas subi de traitement thermique et non revêtue d'une surgrille.

Le tableau suivant montre l'évolution des propriétés optiques, électriques et du taux d'occupation des brins en fonction du traitement thermique. Les durées et méthodes de dépôt de la grille (et de la surgrille) sont les mêmes pour tous les essais.

| Ech XK52 | T recuit (°C) | Temps recuit (min) | R [Ω] | TL (%) | e moyenne grille et surgrille (nm) | % occupé par la grille et surgrille |
|---|---|---|---|---|---|---|
| Sans surgrille ni recuit (Réf) | - | - | 10 | 81,2 | 45 | 11,8 |
| Avec surgrille et recuit | 80 | 5 | 5,02 | 78 | 60 | 14,5 |
| Avec surgrille et recuit | 80 | 15 | 4,1 | 77,4 | 60 | 15,9 |
| Avec surgrille et recuit | 140 | 5 | 3,1 | 70,8 | 120 | 20,5 |
| Avec surgrille et recuit | 140 | 15 | 1,3 | 67,3 | 120 | 25,8 |

On observe l'abaissement de la résistance carré (particulièrement recherchée pour une application électrode) et l'augmentation du taux de couverture mesuré par exemple à partir d'une photographie optique et après traitement d'image. La TL est légèrement diminuée.

### RETRAIT DU MASQUE

Afin de révéler la structure de griffe revêtue de la surgrille à partir du masque, on procède à une opération de « lift off ». Cette opération est facilitée par le fait que la cohésion des colloïdes résulte de forces faibles type Van der Waals (pas de liant, ou de collage résultant par un recuit). Le masque colloïdal est alors immergé dans une solution contenant de l'eau et de l'acétone (on choisit la solution de nettoyage en fonction de la nature des particules colloïdales) puis rincé de manière à ôter toutes les parties revêtues de colloïdes. On pourra accélérer le phénomène grâce à l'utilisation d'ultrasons pour dégrader le masque de particules colloïdales et laisser apparaître les parties complémentaires (le réseau d'ouvertures remplit par le matériau) qui conformeront la grille.

### EXEMPLE DE GRILLE AVEC SURGRILLE DE PROTECTION DE LA CORROSION

On utilise un masque à base de XK52.

On dépose comme matériau de grille de l'aluminium par pulvérisation magnétron à une pression de 4 10⁻³ mbar.

Après recuit, on dépose comme matériau de surgrille, une couche de silice de 35 nm.

| XK52 | Recuit | Taille des mailles | Largeur des ouvertures | R [Ω] | TL (%) | e moyenne grille (et surgrille) | % occupé par la grille (et la surgrille) |
|---|---|---|---|---|---|---|---|
| Avant recuit | - | 20 -40 | 2-4 | 9 | 78 | 300+/- 50 nm | 13,7 |
| Après recuit | 140 (°C) - 15 min | 25-40 | 3-7 | 9 | 78 | 335+/- 50 nm | 23,1 |

Cette grille protégée peut servir par exemple dans un dispositif de blindage EMI ou chauffant typiquement un pare brise ou un radiateur ou une paroi d'une enceinte froide (pour grands magasins, étagères, bacs de congélation..).

### EXEMPLE DE GRILLE AVEC SOUS ET SURGRILLE DE NOIRCISSEMENT

On utilise un masque à base de XK 52.

On dépose d'abord 15 nm de NiCr au travers des ouvertures.

On dépose comme matériau de grille du cuivre de 200 nm par pulvérisation magnétron à une pression de 10⁻³ mbar.

On réalise le traitement thermique

On dépose comme matériau de surgrille, une couche de NiCr de 15 nm.

| XK52 | Recuit | Taille des mailles | Tailles des ouvertures avant recuit | R [Ω] | TL (%) | % occupé par la grille (et la surgrille |
|---|---|---|---|---|---|---|
| Avant recuit | - | 30 -50 | 4 +/-0,5µm | 1,5 | 79 | 14 |
| Après recuit | 110 (°C) -10min | 32 -52 | 4,5 +/-0,5 µm | 1,2 | 77 | 23,1 |

Les 4 côtés du brin de grille deviennent noirs, esthétiques. En incidence rasante, la grille revêtue apparaît noire sur toutes les faces.

Cette grille esthétique sert par exemple pour électrode de lampe plane, d'électrochrome, pour un écran, produits pour lesquels le rendu des couleurs est exigeant.

## Revendications

1. Procédé de fabrication d'une grille électroconductrice submillimétrique (3) revêtue d'une surgrille (4) sur une face principale d'un substrat (2) comportant :
- la réalisation d'un masque (1) à ouvertures submillimétriques, dit masque à réseau, sur la face principale, incluant :
- le dépôt d'une couche de masquage à partir d'une solution de nanoparticules colloïdales polymériques stabilisées et dispersées dans un solvant, les particules polymériques ayant une température de transition vitreuse Tg donnée,
- le séchage de la couche de masquage à une température inférieure à ladite température Tg jusqu'à l'obtention du masque à réseau d'ouvertures (10), avec des bords de zones de masque sensiblement droits,
- la formation de la grille électrocondutrice à partir du masque à réseau comportant un dépôt d'au moins un matériau électroconducteur, dit de grille, jusqu'à remplir une fraction de la profondeur des ouvertures,
- un traitement thermique de la couche de masquage avec le matériau de grille à une température supérieure ou égale à 0,8 fois Tg, conduisant à un rétrécissement des zones du masque, créant ainsi un espace entre les bords de zones de masque et les bords latéraux (31) de la grille,
- un dépôt d'une couche, dite surcouche, en un matériau dit de surcouche, sur la grille et dans l'espace entre les bords de zones de masque (1) et les bords latéraux (31) de la grille.
- un enlèvement de la couche de masquage, jusqu'à laisser révéler la grille électrocondutrice (3) revêtue de la surgrille (4).

2. Procédé selon la revendication précédente, caractérisé en qu'il comprend le dépôt d'une couche (5), dite sous grille, au travers les ouvertures (10) et sous la grille (3), notamment une sous grille d'adhésion de la grille, une sous-grille barrière aux alcalins, une sous grille de noircissement.

3. Procédé selon l'une des revendications précédentes, caractérisé en que le traitement thermique est mis en oeuvre à une température inférieure ou égale à 180°C, encore plus préférentiellement inférieure ou égale à 150°C.

4. Procédé selon l'une des revendications précédentes, caractérisé en que le séchage est mis en oeuvre à une température inférieure égale à 50°C, de préférence à température ambiante.

5. Procédé selon l'une des revendications précédentes, caractérisé en que le dépôt de grille (3), le traitement thermique et le dépôt de surgrille (4) sont réalisés, dans la même enceinte de dépôt, sans rupture du vide.

6. Procédé l'une des revendications précédentes caractérisé en que les nanoparticules polymériques sont choisies parmi l'un ou les polymères suivants : des copolymères acryliques, des polystyrènes, des poly(méth)acrylates, des polyesters ou leurs mélanges.

7. Procédé selon l'une quelconque des revendications précédentes, **caractérisé en ce que** la solution est aqueuse.

8. Procédé l'une quelconque des revendications précédentes, caractérisé en qu'on procède à un enlèvement de la couche de masquage, par voie liquide, notamment par un solvant.

9. Substrat (2), notamment transparent, porteur sur sa face principale d'une grille électroconductrice submillimétrique (3) revêtue d'une surgrille (4), obtenues par le procédé de fabrication selon l'une des revendications 1 à 8.

10. Substrat (2) à grille (3) revêtue selon la revendication précédente **caractérisé en ce que** la surgrille (4) comprend une couche de protection contre la corrosion notamment NiCr, Cr et **en ce que** de préférence est présente une sous grille de protection (5) contre la corrosion, notamment en matériau de surgrille.

11. Substrat (2) à grille (3) revêtue selon l'une des revendications 9 ou 10 **caractérisé en ce qu'**il comprend une sous grille barrière aux alcalins ou de promotion d'adhésion de la grille, notamment NiCr.

12. Substrat (2) à grille revêtue (3) selon l'une des revendications 9 à 11 **caractérisé en ce que** la surgrille (4) comprend une couche de noircissement, avec une pureté en réflexion Pe inférieure à 10% et une longueur d'onde dominante en réflexion autour de 480 nm, notamment une couche de NiCr, et **en ce que** de préférence est présente une sous grille de noircissement (5), notamment en matériau de surgrille.

13. Substrat à grille revêtue selon l'une des revendications 9 ou **caractérisé en ce que** le matériau de surgrille (3) est en ledit matériau de grille (4).

14. Substrat (2) à grille revêtue (3) selon l'une des revendications 9 à 13 **caractérisé en ce que** la grille présente un rapport distance entre les brins (B') sur largeur submillimétrique des brins (A') compris entre 7 et 40, et/ou une largeur A' entre 200 nm et 50 µm et une distance B' entre 5 et 500 µm.

15. Substrat à grille revêtue selon l'une des revendications 9 à 14 **caractérisé en ce que** la grille électroconductrice (3, 4) présente une résistance carré comprise entre 0,1 et 30 Ohm/carré.

16. Substrat (2) à grille revêtue (3) selon l'une des revendications 9 à 15 **caractérisé en ce que** la transmission lumineuse et/ou dans l'ultraviolet et/ou dans l'infrarouge du substrat (2) et de la grille revêtue est comprise entre 70 % à 86 %.

17. Substrat à grille revêtue selon l'une des revendications 9 à 16 **caractérisé en ce qu'**il fait partie d'un vitrage multiple, d'un vitrage feuilleté.

18. Utilisation d'une grille électroconductrice revêtue selon l'une quelconque des revendications 9 à 17 en tant que couche active, notamment électrode ou couche chauffante, dans un dispositif électrochimique, et/ou électrocommandable et à propriétés optiques et/ou énergétiques variables, notamment à cristaux liquides, ou un dispositif photovoltaïque, ou encore un dispositif électroluminescent, notamment organique ou inorganique, ou bien encore un dispositif chauffant, ou éventuellement une lampe plane, une lampe UV plane ou tubulaire, un dispositif de blindage électromagnétique, ou tout autre dispositif nécessitant une couche conductrice, notamment transparente.

## Patentansprüche

1. Verfahren zur Herstellung eines mit einem Übergitter (4) beschichteten elektrisch leitfähigen submillimetrischen Gitters (3) auf einer Hauptfläche eines Substrats (2), umfassend:
- das Ausführen einer Abdeckung (1) mit submillimetrischen Öffnungen, der Gitterabdeckung, auf der Hauptfläche, umfassend:
- das Aufbringen einer Abdeckschicht bestehend aus einer Lösung stabilisierter kolloidaler polymerer Nanopartikel, die in einem Lösungsmittel gelöst sind, wobei die polymeren Partikel eine vorgegebene Glasübergangstemperatur Tg aufweisen,
- das Trocknen der Abdeckschicht bei einer Temperatur, die unter dieser Glasübergangstemperatur Tg liegt, bis zum Erhalt der Gitterabdeckung mit Öffnungen (10), wobei die abgedeckten Bereiche im Wesentlichen gerade Kanten aufweisen,
- das Bilden des elektrisch leitfähigen Gitters aus der Gitterabdeckung, umfassend das Aufbringen mindestens eines elektrisch leitfähigen Materials, also des Gittermaterials, bis ein Anteil der Tiefe der Öffnungen aufgefüllt ist,
- das thermische Behandeln der Abdeckschicht mit dem Gittermaterial bei einer Temperatur, die gleich oder höher als 0,8 mal Tg ist, wobei dies zu einer Schrumpfung der Abdeckbereiche führt, wobei ein Abstand zwischen den Kanten der Abdeckbereiche und den Seitenkanten (31) des Gitters entsteht,
- das Aufbringen einer Schicht, der Überzugsschicht, aus einem Material der Überzugsschicht auf das Gitter und in den Abstand zwischen den Rändern der Abdeckbereiche (1) und der Seitenkanten (31) des Gitters.
- das Entfernen der Abdeckschicht, bis das mit einem Übergitter (4) beschichtete elektrisch leitfähige Gitter (3) offengelegt ist.

2. Verfahren nach dem vorhergehenden Anspruch, **dadurch gekennzeichnet, dass** es das Aufbringen einer Schicht (5), des Untergitters, durch die Öffnungen (10) und unter das Gitter (3) umfasst, insbesondere eines Untergitters zum Anhaften des Gitters, eines Untergitters als Barriere für Alkalimetalle, eines Untergitters zum Schwärzen.

3. Verfahren nach einem der vorhergehenden Ansprüche, **dadurch gekennzeichnet, dass** das thermische Behandeln bei einer Temperatur unterhalb oder gleich 180 °C erfolgt, besonders vorzugsweise unterhalb oder gleich 150 °C.

4. Verfahren nach einem der vorhergehenden Ansprüche, **dadurch gekennzeichnet, dass** das Trocknen bei einer Temperatur unterhalb oder gleich 50 °C erfolgt, vorzugsweise bei Umgebungstemperatur.

5. Verfahren nach einem der vorhergehenden Ansprüche, **dadurch gekennzeichnet, dass** das Aufbringen des Gitters (3), das thermische Behandeln und das Aufbringen des Übergitters (4) vollständig im Vakuum in derselben Beschichtungskammer erfolgen.

6. Verfahren nach einem der vorhergehenden Ansprüche, **dadurch gekennzeichnet, dass** die polymeren Nanopartikel aus einem oder den folgenden Polymeren ausgewählt sind: Acrylcopolymere, Polystyrole, Poly(meth)acrylate, Polyester oder Mischungen derselben.

7. Verfahren nach einem der vorhergehenden Ansprüche, **dadurch gekennzeichnet, dass** die Lösung wässrig ist.

8. Verfahren nach einem der vorhergehenden Ansprüche, **dadurch gekennzeichnet, dass** ein Entfernen der Abdeckschicht mittels einer Flüssigkeit vorgenommen wird, insbesondere mittels eines Lösungsmittels.

9. Substrat (2), insbesondere transparent, auf dessen Hauptfläche ein elektrisch leitfähiges submillimetrisches Gitter (3) angeordnet ist, das mit einem Übergitter (4) beschichtet ist, hergestellt nach Herstellungsverfahren gemäß einem der Ansprüche 1 bis 8.

10. Substrat (2) mit einem beschichteten Gitter (3) nach dem vorhergehenden Anspruch, **dadurch gekennzeichnet, dass** das Übergitter (4) eine Schutzschicht gegen Korrosion umfasst, insbesondere aus NiCr, Cr, und dadurch, dass vorzugsweise ein Schutz-Untergitter (5) gegen Korrosion, insbesondere aus dem Material des Übergitters, vorhanden ist.

11. Substrat (2) mit einem beschichteten Gitter (3) nach einem der Ansprüche 9 oder 10, **dadurch gekennzeichnet, dass** es ein Untergitter als Barriere für Alkalimetalle oder zum Anhaften des Gitters umfasst, insbesondere aus NiCr.

12. Substrat (2) mit einem beschichteten Gitter (3) nach einem der Ansprüche 9 bis 11, **dadurch gekennzeichnet, dass** das Übergitter (4) eine Schwärzungsschicht umfasst, die einen Reflexionsgrad Pe von weniger als 10 % und eine vorherrschende Reflexionswellenlänge von ungefähr 480 nm aufweist, insbesondere eine Schicht aus NiCr, und dadurch, dass vorzugsweise ein Schwärzungs-Untergitter (5), insbesondere aus dem Material des Übergitters, vorhanden ist.

13. Substrat mit einem beschichteten Gitter nach einem der Ansprüche 9 oder, **dadurch gekennzeichnet, dass** das Material des Übergitters (3) aus besagtem Material des Gitters (4) ist.

14. Substrat (2) mit einem beschichteten Gitter (3) nach einem der Ansprüche 9 bis 13, **dadurch gekennzeichnet, dass** das Gitter ein submillimetrisches Distanzverhältnis zwischen den Fasern (B') und den Fasern (A') zwischen 7 und 40 und/oder eine Größe A' zwischen 200 nm und 50 µm und eine Distanz B' zwischen 5 und 500 µm aufweist.

15. Substrat mit einem beschichteten Gitter nach einem der Ansprüche 9 bis 14, **dadurch gekennzeichnet, dass** das elektrisch leitfähige Gitter (3, 4) einen Flächenwiderstand zwischen 0,1 und 30 Ohm/Fläche aufweist.

16. Substrat (2) mit einem beschichteten Gitter (3) nach einem der Ansprüche 9 bis 15, **dadurch gekennzeichnet, dass** die Lichttransmission und/oder Transmission im Ultraviolett- und/oder Infrarotspektrum des Substrats (2) und des beschichteten Gitters zwischen 70 % und 86 % liegt.

17. Substrat mit einem beschichteten Gitter nach einem der Ansprüche 9 bis 16, **dadurch gekennzeichnet, dass** es Teil einer Mehrfachverglasung, einer Verbundverglasung ist.

18. Verwendung eines elektrisch leitfähigen, beschichteten Gitters nach einem der Ansprüche 9 bis 17 als aktive Schicht, insbesondere Elektrode oder Heizschicht, in einer elektrochemischen Vorrichtung, und/oder elektrisch steuerbar und mit variablen optischen und/oder energetischen Eigenschaften, insbesondere mit Flüssigkristallen, oder in einer fotovoltaischen Vorrichtung, oder auch in einer elektrolumineszenten Vorrichtung, insbesondere organisch oder anorganisch, oder wiederum in einer Heizvorrichtung, oder eventuell einer Flachlampe, einer flachen oder röhrenförmigen UV-Lampe, einer elektromagnetischen Abschirmvorrichtung oder jeder anderen Vorrichtung, die eine leitfähige, insbesondere transparente, Schicht benötigt.

## Claims

1. Process for manufacturing a submillimetric electroconductive grid (3) coated with an overgrid (4) on a main face of a substrate (2) comprising:
- producing a mask (1) having submillimetric openings, referred to as a network mask, on the main face, including:
- the deposition of a masking layer from a solution of colloidal polymeric nanoparticles that are stabilized and dispersed in a solvent, the polymeric particles having a given glass transition temperature Tg;
- the drying of the masking layer at a temperature below said temperature Tg until the mask having a network of openings (10) with substantially straight edges of mask zones is obtained;
- the formation of the electroconductive grid from the network mask, comprising a deposition of at least one electroconductive material, referred to as grid material, until a fraction of the depth of the openings is filled;
- a heat treatment of the masking layer with the grid material at a temperature greater than or equal to 0.8 times Tg, resulting in a shrinkage of the mask zones, thus creating a space between the edges of mask zones and the lateral edges (31) of the grid;
- a deposition of a layer, referred to as an overlayer, made of a material referred to as overlayer material, on the grid and in the space between the edges of mask zones (1) and the lateral edges (31) of the grid;
- a removal of the masking layer, until the electroconductive grid (3) coated with the overgrid (4), is revealed.

2. Process according to the preceding claim, **characterized in that** it comprises the deposition of a layer (5), referred to as undergrid, through the openings (10) and under the grid (3), especially an undergrid for adhesion of the grid, an undergrid that is a barrier to alkali metals, a darkening undergrid.

3. Process according to either of the preceding claims, **characterized in that** the heat treatment is carried out at a temperature of less than or equal to 180°C, more preferably still less than or equal to 150°C.

4. Process according to one of the preceding claims, **characterized in that** the drying is carried out at a temperature of less than or equal to 50°C, preferably at ambient temperature.

5. Process according to one of the preceding claims, **characterized in that** the deposition of grid (3), the heat treatment and the deposition of overgrid (4) are carried out, in the same deposition chamber, without breaking the vacuum.

6. Process according to one of the preceding claims, **characterized in that** the polymeric nanoparticles are chosen from one of or the following polymers: acrylic copolymers, polystyrenes, poly(meth)acrylates, polyesters or blends thereof.

7. Process according to any one of the preceding claims, **characterized in that** the solution is aqueous.

8. Process according to any one of the preceding claims, **characterized in that** the masking layer is removed via a liquid route, in particular by a solvent.

9. Substrate (2), in particular a transparent substrate, bearing on its main face a submillimetric electroconductive grid (3) coated with an overgrid (4) obtained by the manufacturing process according to one of Claims 1 to 8.

10. Substrate (2) with a coated grid (3) according to the preceding claim, **characterized in that** the overgrid (4) comprises a corrosion-protective layer in particular NiCr, Cr and **in that** a corrosion-protective undergrid (5) is preferably present, in particular made of overgrid material.

11. Substrate (2) with a coated grid (3) according to either of Claims 9 and 10, **characterized in that** it comprises an undergrid that is a barrier to alkali metals or for promoting adhesion of the grid, in particular NiCr.

12. Substrate (2) with a coated grid (3) according to one of Claims 9 to 11, **characterized in that** it the overgrid (4) comprises a darkening layer, with a purity in reflection Pe of less than 10% and a dominant wavelength in reflection around 480 nm, in particular a layer of NiCr, and **in that** a darkening undergrid (5) is preferably present, in particular made of overgrid material.

13. Substrate with a coated grid according to one of Claims 9 to 12, **characterized in that** the overgrid (3) material is made of said grid (4) material.

14. Substrate (2) with a coated grid (3) according to one of Claims 9 to 13, **characterized in that** the grid has a ratio of the distance between the strands (B') to the submillimetric width of the strands (A') that is between 7 and 40, and/or a width A' between 200 nm and 50 µm and a distance B' between 5 and 500 µm.

15. Substrate with a coated grid according to one of Claims 9 to 14, **characterized in that** the electroconductive grid (3, 4) has a sheet resistance between 0.1 and 30 ohm/square.

16. Substrate (2) with a coated grid (3) according to one of Claims 9 to 15, **characterized in that** the light transmission and/or the transmission in the ultraviolet and/or in the infrared of the substrate (2) and of the coated grid is between 70% and 86%.

17. Substrate with a coated grid according to one of Claims 9 to 16, **characterized in that** it is part of a multiple glazing unit or a laminated glazing unit.

18. Use of a coated electroconductive grid according to any one of Claims 9 to 17 as an active layer, in particular a heating layer or electrode, in an electrochemical and/or electrically controllable device having variable optical and/or energy properties, in particular a liquid crystal device, or a photovoltaic device, or else a light-emitting device, in particular an organic or inorganic light-emitting device, or else a heating device, or optionally a flat lamp, a flat or tubular UV lamp, an electromagnetic shielding device, or any other device requiring a conductive, in particular transparent, layer.
